# EUROPEAN PATENT APPLICATION

(11) **EP 4 471 864 A1**
(43) Date of publication of application: **04.12.2024**
(21) Application number: 22926188.8
(22) Date of filing: 14.11.2022
(51) Int. Cl.: H01L 27/15, H01L 33/58, H01L 33/52

(54) **DISPLAY DEVICE USING LIGHT-EMITTING ELEMENT AND MANUFACTURING METHOD THEREOF**

(30) Priority: 11.02.2022 KR 20220018228
(71) Applicant: LG Electronics Inc., Yeongdeungpo-gu Seoul 07336 (KR)
(72) Inventor: YOON, Dongjin, Seoul 06772 (KR); PARK, Sangtae, Seoul 06772 (KR); LEE, Sangyeol, Seoul 06772 (KR); OH, Jeongtak, Seoul 06772 (KR); KIM, Sungkyoon, Seoul 06772 (KR); PARK, Sunwoo, Seoul 06772 (KR)
(74) Representative: Schornack, Oliver
(86) International application number: PCT/KR2022/017887
(87) International publication number: WO 2023/153590

(57) **Abstract**

The present invention is applicable to the technical field of display devices and relates to a display device which uses, for example, a light-emitting diode (LED). To achieve the aforementioned objective, the present invention comprises: a wiring board; a light-emitting element which is composed of individual pixels and arranged on the wiring board; an insulation layer which is located at least on a side surface of the light-emitting element; and a black-colored layer which is located on the insulation layer, wherein the black-colored layer may include a material formed by modifying the material constituting the insulation layer.

## Description

### TECHNICAL FIELD

The present disclosure is applicable to a technical field related to a display device and relates to a display device using a Light Emitting Diode (LED) and a method of fabricating the same.

### BACKGROUND ART

As the information society develops, demand for a display device increases in various forms, and in response thereto, various display devices such as a Liquid Crystal Display (LCD) device, a Plasma Display Panel (PDP), an Electro Luminescent Display (ELD), a Vacuum Fluorescent Display (VFD), an Organic Light Emitting Diode (OLED), a Micro Light Emitting Diode (Micro LED), and the like are being studied and used.

A digital signage is a display device that provides specific information as well as a broadcasting program in public places such as airport, hotel, hospital, and subway station, and the like, as a communication tool capable of inducing marketing, advertisement, training effects, and customer experience of enterprises as well as a general TV.

A digital signage is a medium for displaying various contents and commercial advertisements by installing a display panel such as a Liquid Crystal Display (LCD), a Plasma Display Panel (PDP), an Organic Light Emitting Diode (OLED), a Micro LED Light Emitting Diode (LED), etc. in certain outdoor places or devices such as street furniture, and may be installed on public movement lines such as apartment elevators, subway stations, subway trains, buses, universities, banks, convenience stores, discount stores, and shopping malls, and the like.

Recently, many studies have been conducted to improve an image quality of a display panel while the digital signage is large- or ultra-large sized.

Such digital signage is implemented as a modular display device in which various display modules are configured to be combined. Such a module display may use a Light Emitting Diode (LED) as a pixel.

When a light emitting device is used as a pixel (light source), when a black film is not applied to an upper side of the light emitting device, a central pixel area may be brightly represented but a periphery of the light source may not be represented sufficiently dark. This may be a phenomenon in which a sapphire used in the light emitting device has a large reflectivity with respect to an external incident light.

In addition, when the black film is applied, the periphery of the light source may be represented to be sufficiently dark but the central white area may be darkened together by the application of the black film.

Accordingly, contrast of a display may be reduced and a sufficient grayscale representation may be difficult.

Therefore, a demand for a solution for such problems has emerged.

### DISCLOSURE

### TECHNICAL TASKS

One technical task of the present disclosure is to provide a display device using a light emitting device and fabricating method thereof, by which light efficiency may be improved.

Another technical task of the present disclosure is to provide a display device using a light emitting device and fabricating method thereof, by which a grayscale representation by a light source may be widely implemented.

Another technical task of the present disclosure is to provide a stacked light emitting device and display device using the same, which may increase light efficiency by allowing light traveling to a side surface of a light emitting device to travel on a front surface,.

Another technical task of the present disclosure is to provide a stacked light emitting device and display device using the same, which may uniformize a viewing angle due to different light distribution characteristics among red, green, and blue.

Another technical task of the present disclosure is to provide a stacked light emitting device and display device using the same, which may improve a phenomenon in which a bright line occurs between modules when the display device has module structures connected to each other.

Furthermore, the technical tasks to be achieved in the embodiments are not limited to the above-mentioned matters, and other unmentioned technical tasks may be considered by those skilled in the art from various embodiments to be described below.

### TECHNICAL SOLUTIONS

In a first technical aspect of the present disclosure, provided is a display device including a wiring substrate, a light emitting device disposed as an individual pixel on the wiring substrate, an insulating layer positioned on at least a side surface of the light emitting device, and a black layer positioned on the insulating layer, wherein the black layer may include a material formed by transforming a material forming the insulating layer.

The black layer may include a material formed by carbonizing particles included in the insulating layer.

The black layer may include a material formed by decomposing particles included in the insulating layer by heat.

The material decomposed by the heat may include non-crystalline carbon and amorphous powder.

The black layer may have a predetermined thickness on the insulating layer.

The insulating layer may act as a reflective layer.

The insulating layer may include a transparent resin layer and particles dispersed in the transparent resin layer.

The transparent resin layer may include at least one of silicon, epoxy, or urethane.

The particle may include at least one of silicon oxide, titanium oxide, or zirconium oxide.

A refractive index of the particle may be different from that of the transparent resin layer.

The light emitting device may include a semiconductor structure having a plurality of semiconductor layers stacked to emit light of a first color, a second color, and a third color.

The light emitting device may include a support layer on the semiconductor structure.

The insulating layer may be positioned to further surround a side surface of the support layer.

The black layer may be positioned to surround at least a portion of a side surface of the support layer.

In a second technical aspect of the present disclosure, provided is a method of fabricating a display device using a light emitting device, the method including disposing a plurality of light emitting devices forming individual pixels on a wiring substrate, forming an insulating layer including particles dispersed in a transparent resin layer between the light emitting devices, and forming a black layer by applying heat to the insulating layer.

The applying the heat to the insulating layer may be performed by laser irradiation.

The forming the black layer may include thermally decomposing particles included in the insulating layer by applying the heat.

A lens may be positioned on the light emitting device so as not to react to the laser irradiation.

### ADVANTAGEOUS EFFECT

First, according to an embodiment of the present disclosure, a light source (light emitting device) side may be represented bright sufficiently, and a periphery of the light source may be represented sufficiently dark. Accordingly, a grayscale representation by the light source may be widely implemented.

In addition, since a black layer is not positioned on a light emitting device, an overall brightness of a display device may be improved.

In addition, the light traveling to a side surface of a light emitting device is allowed to travel to a front surface, thereby increasing light efficiency.

In addition, viewing angles due to different light distribution characteristics among red, green, and blue may be uniformized.

In addition, when a display device has a module structure connected to each other, a phenomenon in which a bright line occurs between modules may be improved.

In addition, a size of a light emitting device may be substantially expanded.

The effects obtained from the embodiments are not limited to the effects mentioned above, and other unmentioned effects may be clearly derived and understood by those skilled in the art based on the following detailed description.

### DESCRIPTION OF DRAWINGS

FIG. 1 is a cross-sectional diagram illustrating pixel regions of a display device using a light emitting device according to an embodiment of the present disclosure.
FIG. 2 is a cross-sectional diagram illustrating a unit pixel region of a display device using a light emitting device according to an embodiment of the present disclosure.
FIG. 3 is an enlarged diagram illustrating a display device using a light emitting device according to an embodiment of the present disclosure.
FIG. 4 is a cross-sectional diagram illustrating a light emitting device of a display device using the light emitting device according to an embodiment of the present disclosure.
FIG. 5 is a cross-sectional diagram illustrating a modified example of the light emitting device of FIG. 4.
FIG. 6 is a cross-sectional diagram illustrating a light emitting device of a display device using the light emitting device according to another embodiment of the present disclosure.
FIG. 7 is a cross-sectional diagram illustrating a modified example of the light emitting device of FIG. 6.
FIG. 8 is a cross-sectional diagram illustrating a display device using a light emitting device according to another embodiment of the present disclosure.
FIG. 9 is a schematic cross-sectional diagram illustrating a process of fabricating a display device using a light emitting device according to an embodiment of the present disclosure.
FIG. 10 is a schematic diagram illustrating a partial region of FIG. 9.
FIG. 11 is a flowchart illustrating a process of fabricating a display device using a light emitting device according to an embodiment of the present disclosure.
FIG. 12 is a diagram illustrating an example of a grayscale representation in a state in which a black film is formed on a front surface of a display device as a comparative example.
FIG. 13 is a diagram illustrating an example of a grayscale representation of a display device using a light emitting device according to an embodiment of the present disclosure.

### BEST MODE

Reference will now be made in detail to embodiments of the present disclosure, examples of which are illustrated in the accompanying drawings. Wherever possible, the same reference numbers will be used throughout the drawings to refer to the same or like parts, and redundant description thereof will be omitted. As used herein, the suffixes "module" and "unit" are added or used interchangeably to facilitate preparation of this specification and are not intended to suggest distinct meanings or functions. In describing embodiments disclosed in this specification, relevant well-known technologies may not be described in detail in order not to obscure the subject matter of the embodiments disclosed in this specification. In addition, it should be noted that the accompanying drawings are only for easy understanding of the embodiments disclosed in the present specification, and should not be construed as limiting the technical spirit disclosed in the present specification.

Furthermore, although the drawings are separately described for simplicity, embodiments implemented by combining at least two or more drawings are also within the scope of the present disclosure.

In addition, when an element such as a layer, region or module is described as being "on" another element, it is to be understood that the element may be directly on the other element or there may be an intermediate element between them.

A display device described in the present specification is a concept including all display devices displaying information as a unit pixel or a set of unit pixels. Therefore, the present disclosure is not limited to a finished product and may be applicable to a component. For example, a panel corresponding to one component of a digital TV may also independently correspond to a display device of the present specification. The finished product may include a mobile phone, a smart phone, a laptop computer, a digital broadcasting terminal, Personal Digital Assistants (PDA), a Portable Multimedia Player (PMP), a navigation, a slate PC, a tablet PC, an Ultra Book, a digital TV, a desktop computer, etc.

However, it will be readily apparent to those skilled in the art that the configuration according to embodiments described herein may be applied to a device capable of displaying even in the form of a new product to be developed later.

In addition, the semiconductor light emitting device mentioned in this specification is a concept including an LED, a micro LED, and the like, which may be used in a mixed manner.

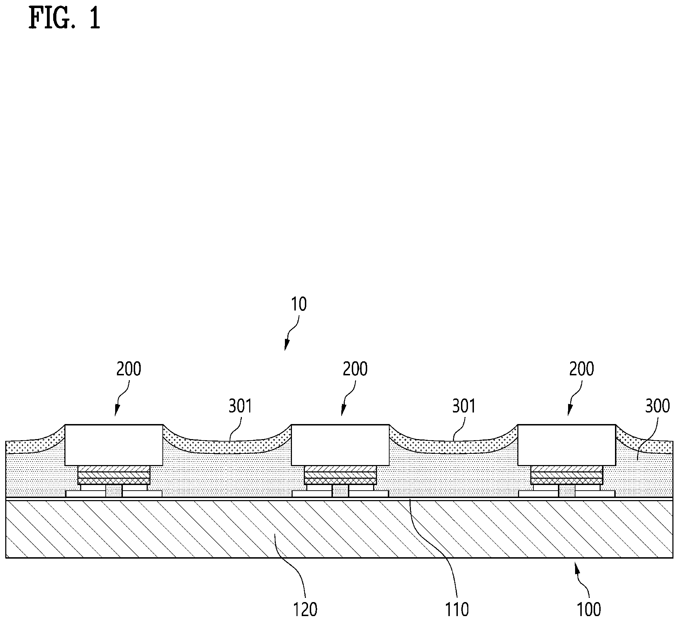

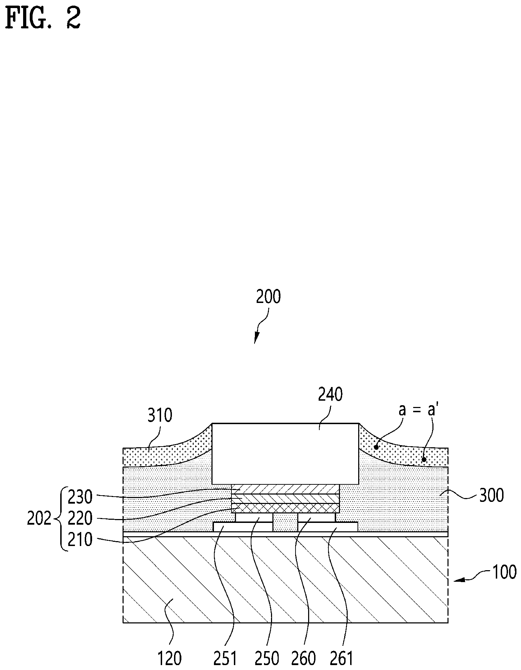

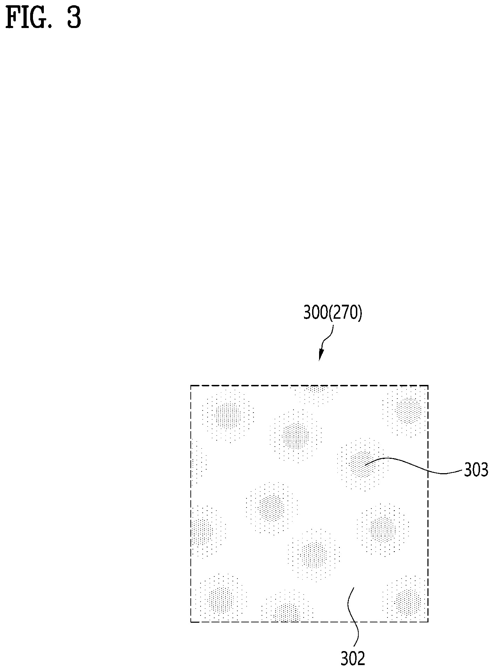

FIG. 1 is a cross-sectional diagram illustrating pixel regions of a display device using a light emitting device according to an embodiment of the present disclosure. FIG. 2 is a cross-sectional diagram illustrating a unit pixel region of a display device using a light emitting device according to an embodiment of the present disclosure. FIG. 3 is an enlarged diagram illustrating a display device using a light emitting device according to an embodiment of the present disclosure.

Referring to FIG. 1, in a display device 10, light emitting devices 200 that form a plurality of pixels may be arranged on a wiring substrate 100 including a base substrate 120 provided with a wiring electrode 110.

In this case, an insulating layer 300 may be disposed between a plurality of the light emitting devices 200. The insulating layer 300 may be disposed on at least a side surface of the light emitting device 200 to surround the side surface of the light emitting device 200.

In addition, as shown in FIG. 1, the insulating layer 300 may be provided to fill a space between the light emitting devices 200.

A black layer 310 may be disposed on the insulating layer 300. The black layer 310 may serve as a black matrix layer that improves contrast of the display device 10.

The black layer 310 may include a material formed by transforming a material forming the insulating layer 300. In an exemplary embodiment, the black layer 310 may include a material formed by carbonizing particles included in the insulating layer 300.

In other words, the black layer 310 may include a material in which particles included in the insulating layer 300 are decomposed by heat. In this case, the material decomposed by the heat may include non-crystalline carbon.

The black layer 310 may be formed by carbonization of a resin included in the insulating layer 300. This carbonization phenomenon may be a phenomenon in which an organic material is pyrolyzed under appropriate conditions to generate non-crystalline carbon-black amorphous micropowder (soot). This will be described in detail later.

As shown in FIG. 1, in an exemplary embodiment, the black layer 310 may have a predetermined thickness on the insulating layer 300. However, depending on embodiments, the thickness of the black layer 310 may vary depending on a distance between the light emitting devices 200.

The insulating layer 300 may serve as a reflective layer. That is, the insulating layer 300 may serve as a reflective layer that reflects light emitted from the light emitting device 200 to the side surface. Meanwhile, the insulating layer 300 may insulate a first electrode 250 and a second electrode 260 of the light emitting device 200. In addition, the insulating layer 300 may act as a layer that fills a space between the light emitting devices 200 to planarize. Hereinafter, the insulating layer 300 and the reflective layer 300 may be interchangeably described, and will be described using the same reference number.

Referring to FIG. 3, the insulating layer 300 may include particles 303 dispersed in a transparent resin layer 302. The particles 303 may act as reflective particles. This will be described in detail later.

In FIG. 1, the wiring electrode 110 is briefly illustrated. A plurality of wiring electrodes 110 may be divided and positioned on the wiring substrate 110. Here, the wiring electrode 110 may include a data electrode (pixel electrode) and a scan electrode (common electrode).

Although not shown, the wiring electrode 110 arranged on the wiring substrate 100 may be connected to a TFT layer provided with a Thin Film Transistor (TFT). The data electrode (pixel electrode) may be connected to the TFT layer. A detailed description thereof will be omitted.

In an exemplary embodiment, as illustrated, the insulating layer 300 may have a hang structure 301 between the light emitting devices 200 neighboring to each other. That is, a curved structure 301 which is concavely formed between the neighboring light emitting devices 200 and continuously extends may be formed on a top surface of the insulating layer 300.

In other words, a maximum height of the light emitting device 200 and a minimum height of the insulating layer 300 may be different from each other. For example, the minimum height of the insulating layer 300 may be lower than the maximum height of the light emitting device 200. In other words, the height of the hang structure 301 may be higher than half of the height of the light emitting device 200.

The hang structure 301 may be associated with a fabricating process of the insulating layer 300. For example, when the insulating layer 300 is formed using a jetting process of coating a material using a nozzle and then curing the material, the hang structure 301 may be formed.

The light emitting device 200 may be disposed on the wiring substrate 100 while forming an individual pixel. For example, a single light emitting device 200 may be configured to form a single pixel. Since the insulating layer 300 surrounding at least a side surface of the single light emitting device 200 constituting the individual pixel and acting as a reflective layer is formed, light emitted from the light emitting device 200 may be emitted upward without being mixed with light emitted from another light emitting device 200 constituting a neighboring pixel.

That is, since light is emitted in all directions from the light emitting device 200, the light emitted laterally from the individual light emitting devices 200 may be reflected by the insulating layer 300 and emitted toward an upper side of the display device 10.

Accordingly, since light emitted from the light emitting device 200 and traveling to the side surface is blocked by the insulating layer 300, it is possible to fundamentally prevent a phenomenon in which a bright line is generated between the pixels in the display device 10.

Referring to FIG. 2, for example, the light emitting device 200 constituting the individual pixel may include a semiconductor structure 202 including a plurality of semiconductor layers 210, 220, and 230 stacked to emit light of a first color, a second color, and a third color.

As a specific example, the light emitting device 200 may be a stacked semiconductor light emitting device capable of emitting red, green, and blue light.

For example, the stacked light emitting device 200 may include a semiconductor structure 202 including a first semiconductor layer 210 emitting red light, a second semiconductor layer 220 emitting blue light, and a third semiconductor layer 230 emitting green light.

Here, the first semiconductor layer 210, the second semiconductor layer 220, and the third semiconductor layer 230 may include semiconductor layers capable of emitting lights of individual colors, respectively. For example, each of the first semiconductor layer 210, the second semiconductor layer 220, and the third semiconductor layer 230 may include an active layer capable of emitting light of an individual color. As another example, each of the first semiconductor layer 210, the second semiconductor layer 220, and the third semiconductor layer 230 may include a n-type semiconductor layer and a p-type semiconductor layer together with an active layer capable of emitting light of an individual color. Such an individual structure is omitted from FIG. 2.

In addition, the light emitting device 200 may include a first electrode 250 and a second electrode 260 electrically connected to one side and the other side of the semiconductor structure, respectively. In FIG. 2, an electrical connection structure of the semiconductor structure, the first electrode 250, and the second electrode 260 is briefly illustrated.

A support layer 240 may be disposed on the semiconductor structure 202. Here, the support layer 240 may be a growth substrate in which the semiconductor structure 202 is grown or a transfer substrate in which the semiconductor structure 202 is transferred and bonded. The support layer 240 may be transparent to light emitted from the semiconductor structure 202. For example, the support layer 240 may include a sapphire substrate.

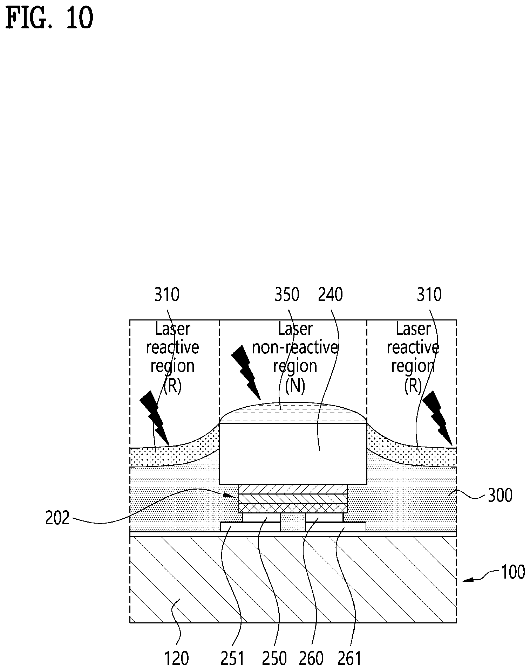

According to an embodiment, a lens 350 (see FIG. 10) may be disposed on the support layer 240. The lens 350 does not react in the process of forming the black layer 310 so that the light emitting device 200 is allowed not to react with heat.

Meanwhile, the first electrode 250 and the second electrode 260, which are electrically connected to one side and the other side of the semiconductor structure 202, respectively, may be provided with extension pads 251 and 261, respectively. A size of each of the extension pads 251 and 261 may become greater than an outer surface of the semiconductor structure 202.

The light emitting device 200 as a light source will be described later in detail.

Here, the insulating layer 300 acts as a reflective layer and may be positioned to surround at least the side surface of the semiconductor structure 202 including the first semiconductor layer 210, the second semiconductor layer 220, and the third semiconductor layer 230 of the light emitting device 200.

In addition, the insulating layer 300 may be positioned to cover the first electrode 250 and the second electrode 260. In addition, for example, the insulating layer 300 may be positioned to cover the extension pads 251 and 261.

The insulating layer 300 may be positioned to further surround a side surface of the support layer 240 of the light emitting device 200. For example, the insulating layer 300 may be positioned to surround all surfaces except for a top surface of the support layer 240 of the light emitting device.

As described above, the black layer 310 may have a predetermined thickness on the insulating layer 300. That is, a thickness 'a' of the black layer 310 at a portion close to the light emitting device 200 may be the same as a thickness 'a" of a portion of the black layer 310 relatively far from the light emitting device 200.

This may mean that the predetermined thickness is formed along the insulating layer 300 by the above-mentioned carbonization (or pyrolysis) process. In addition, it may mean that the black layer 310 may be formed in a manner that a heat source for carbonization (or pyrolysis) penetrates into the insulating layer to a predetermined depth irrespective of a position.

Referring to FIG. 3, the insulating layer 300 may include particles 303 dispersed in the transparent resin layer 302. These particles 303 may act as reflective particles.

In an exemplary embodiment, a refractive index of the particle 303 may be different from that of the transparent resin layer 302.

The particle 303 may include at least one of silicon, titanium, zirconium, or an oxide thereof, e.g., silicon oxide (SiOₓ), titanium oxide (TiOₓ), or zirconium oxide (ZrOₓ).

Meanwhile, the transparent resin layer 302 may be formed of a resin material. For example, the transparent resin layer 302 may include at least one of silicon, epoxy, and urethane.

A thickness of the insulating layer 300 may be set to have a reflectivity of 90% or more by the transparent resin layer 302 and the particles 303.

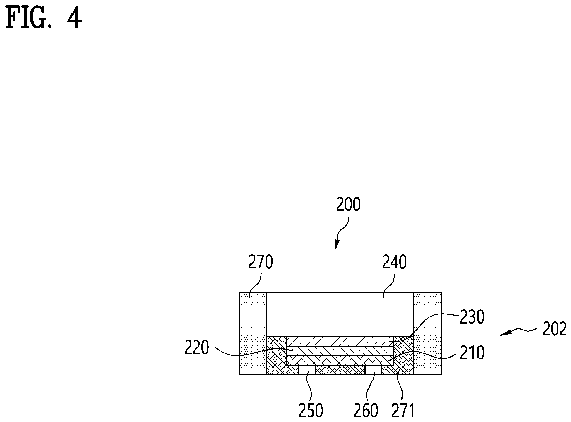

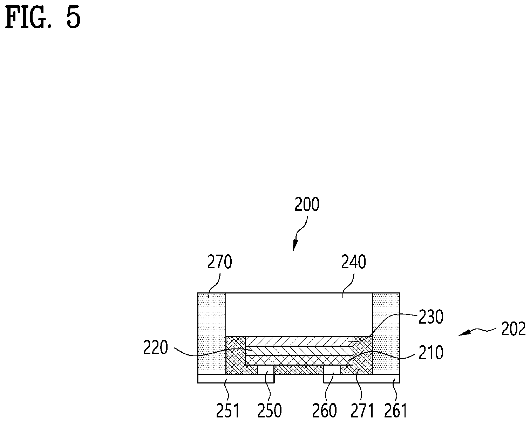

FIG. 4 is a cross-sectional diagram illustrating a light emitting device of a display device using the light emitting device according to an embodiment of the present disclosure. FIG. 5 is a cross-sectional diagram illustrating a modified example of the light emitting device of FIG. 4.

Referring to FIG. 4, a light emitting device 201 constituting an individual pixel may include a semiconductor structure 202 including a plurality of semiconductor layers 210, 220, and 230 stacked to emit light of a first color, a second color, and a third color.

As a specific example, the light emitting device 201 may be a stacked semiconductor light emitting device capable of emitting red, green, and blue light.

For example, the stacked light emitting device 201 may include a semiconductor structure 202 including a first semiconductor layer 210 emitting red light, a second semiconductor layer 220 emitting blue light, and a third semiconductor layer 230 emitting green light.

Here, the first semiconductor layer 210, the second semiconductor layer 220, and the third semiconductor layer 230 may include semiconductor layers capable of emitting light of individual colors, respectively. For example, each of the first semiconductor layer 210, the second semiconductor layer 220, and the third semiconductor layer 230 may include an active layer capable of emitting light of an individual color. As another example, each of the first semiconductor layer 210, the second semiconductor layer 220, and the third semiconductor layer 230 may include a n-type semiconductor layer and a p-type semiconductor layer together with an active layer capable of emitting light of an individual color.

In addition, the light emitting device 201 may include a first electrode 250 and a second electrode 260 electrically connected to one side and the other side of the semiconductor structure 202, respectively.

A support layer 240 may be disposed on the semiconductor structure 202. Here, the support layer 240 may be a growth substrate in which the semiconductor structure 202 is grown or a transfer substrate in which the semiconductor structure 202 is transferred and bonded. A surface direction size of the support layer 240 may be greater than the semiconductor structure 202.

A reflective layer 270 and 271 may be disposed on a side surface of the semiconductor structure 202 of the light emitting device 201.

Here, the reflective layer 270 and 271 may be positioned to surround the side surface of the semiconductor structure 202 including at least the first semiconductor layer 210, the second semiconductor layer 220, and the third semiconductor layer 230 of the light emitting device 200.

In addition, the reflective layer 270 and 271 may be positioned to cover the first electrode 250 and the second electrode 260.

The reflective layer 270 and 271 may be positioned to further surround the side surface of the support layer 240 of the light emitting device 201. For example, the insulating layer 270 may be positioned to surround all surfaces except for a top surface of the support layer 240 of the light emitting device.

In this case, as an exemplary embodiment, the reflective layer may include a first reflective layer 271 covering side and bottom surfaces of the semiconductor structure including the first semiconductor layer 210, the second semiconductor layer 220, and the third semiconductor layer 230 and a second reflective layer 270 covering side surfaces of the first reflective layer 271 and the support layer 240.

The reflective layer 270 and 271 may substantially extend a size of the light emitting device 201. A light emitting surface of the light emitting device 201 may be expanded to a size including the reflective layer 270 and 271. That is, the light emitting surface having an area corresponding to the semiconductor structure may be expanded to a size including the reflective layers 270 and 271.

Referring to FIG. 5, extension pads 251 and 261 respectively connected to the first electrode 250 and the second electrode 260 may be further provided.

A size of the extension pad 251/261 may become greater over an outer surface of the semiconductor structure 202. For example, the size of the extension pad 251/261 may be extended to an outer surface of the reflective layer 270.

In this case, top surfaces of the extension pads 251 and 261 may be in contact with the reflective layer 270 and 271. The extension pad 251/261 may further improve the reflectivity of the reflective layer 270/271. In addition, the extension pad 251/261 may form a substantially external electrode pad of the light emitting device 201.

For other matters not described, the matters described above with reference to FIGs. 1 to 3 may be applied as they are. For example, as described with reference to FIG. 3, the reflective layer 270 and 271 may include particles 303 dispersed in the transparent resin layer 302. That is, the characteristics of the reflective layer 270 and 271 of the present embodiment may be substantially the same as those of the reflective layer 300 described above. In other words, the characteristics of the reflective layer 270 and 271 of the present embodiment except for the characteristics having the hang structure 301 may be the same as those of the reflective layer 300 described above. Therefore, redundant descriptions will be omitted.

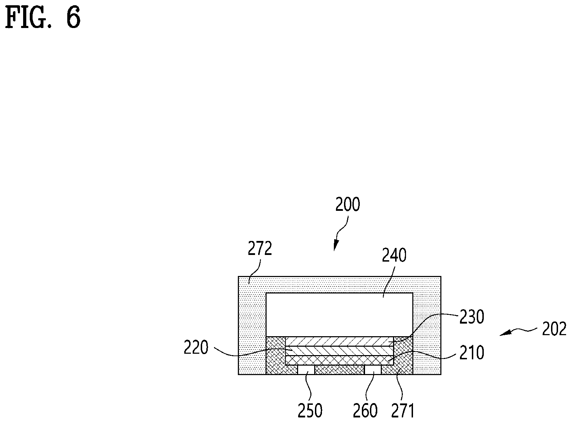

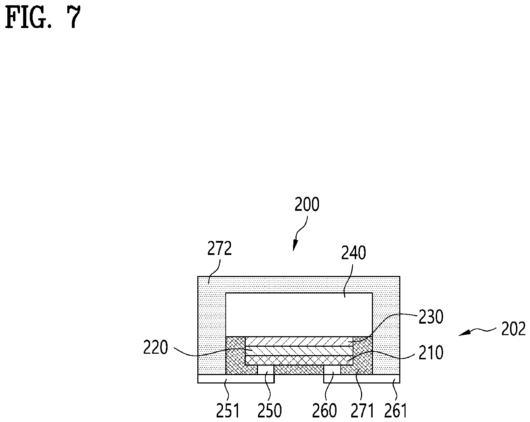

FIG. 6 is a cross-sectional diagram illustrating a light emitting device of a display device using the light emitting device according to another embodiment of the present disclosure. FIG. 7 is a cross-sectional diagram illustrating a modified example of the light emitting device of FIG. 6.

Referring to FIG. 6, a light emitting device 201 constituting an individual pixel may include a semiconductor structure 202 including a plurality of semiconductor layers 210, 220, and 230 stacked to emit light of a first color, a second color, and a third color. Since the semiconductor structure 202 is the same as that described with reference to FIG. 4, a redundant description thereof will be omitted.

In addition, the light emitting device 201 may include a first electrode 250 and a second electrode 260 electrically connected to one side and the other side of the semiconductor structure 202, respectively.

A support layer 240 may be disposed on the semiconductor structure 202. Here, the support layer 240 may be a growth substrate in which the semiconductor structure 202 is grown or a transfer substrate in which the semiconductor structure 202 is transferred and bonded. A surface direction size of the support layer 240 may be greater than the semiconductor structure 202.

A reflective layer 271 and 272 may be disposed on a side surface of the semiconductor structure 202 of the light emitting device 201.

In an exemplary embodiment, the reflective layer may include a first reflective layer 271 covering a side surface of the semiconductor structure 202 including the first semiconductor layer 210, the second semiconductor layer 220, and the third semiconductor layer 230 and side surfaces of the first electrode 250 and the second electrode 260 and a second reflective layer 272 covering side and top surfaces of the first reflective layer 271 and the support layer 240.

As described above, the second reflective layer 272 may be positioned to surround the side and top surfaces of the support layer 240 of the light emitting device 201. The second reflective layer 272 may improve uniformity of light emitted from the light emitting device 201.

The reflective layer 271 and 272 may substantially extend a size of the light emitting device 201. A light emitting surface of the light emitting device 201 may be expanded to a size including the reflective layer 271 and 272. That is, the light emitting surface having an area corresponding to the semiconductor structure 202 may be expanded to a size including the reflective layer 271 and 272.

Referring to FIG. 7, extension pads 251 and 261 respectively connected to the first electrode 250 and the second electrode 260 may be further provided.

A size of the extension pads 251 and 261 may become greater over an outer surface of the semiconductor structure 202. For example, the size of the extension pads 251 and 261 may be expanded to an outer surface of the reflective layer 272.

In this case, top surfaces of the extension pads 251 and 261 may be in contact with the reflective layer 271 and 272. The extension pads 251 and 261 may further improve reflectivity of the reflective layer 271 and 272. In addition, the extension pad 251/261 may form a substantially external electrode pad of the light emitting device 201.

For other matters not described, the matters described with reference to FIGS. 1 to 5 above may be applied as they are. For example, as described with reference to FIG. 3, the reflective layer 271/272 may include particles 303 dispersed in the transparent resin layer 302. That is, the characteristics of the reflective layer 271/272 of the present embodiment may be substantially the same as those of the reflective layer 300 described above. In other words, the characteristics of the reflective layer 271/272 of the present embodiment except for the characteristics having the hang structure 301 may be the same as those of the reflective layer 300 described above. Therefore, redundant descriptions will be omitted.

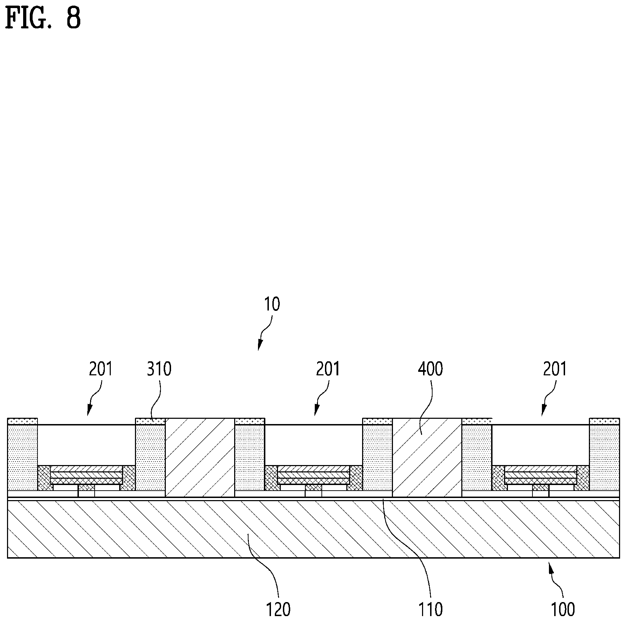

FIG. 8 is a cross-sectional diagram illustrating a display device using a light emitting device according to another embodiment of the present disclosure.

Referring to FIG. 8, an embodiment of the display device 10 in which the light emitting device 201 according to the embodiment of FIG. 4 forms an individual pixel is illustrated.

That is, the light emitting device 201 according to the embodiment of FIG. 5 may be installed on a wiring substrate 100 to form an individual pixel. In this case, a gap layer 400 may filled a space between the individual light emitting devices 201.

As described above, the display device 10 may be implemented in a simple structure by using the light emitting device 201 having the structure expanded by a reflective layer 270, 271, and 272.

In this case, a module display device 10 having a predetermined number of light emitting devices 201 may be implemented on the wiring substrate 100 having a predetermined size. The display device 10 having a desired size may be fabricated by combining the module display device 10.

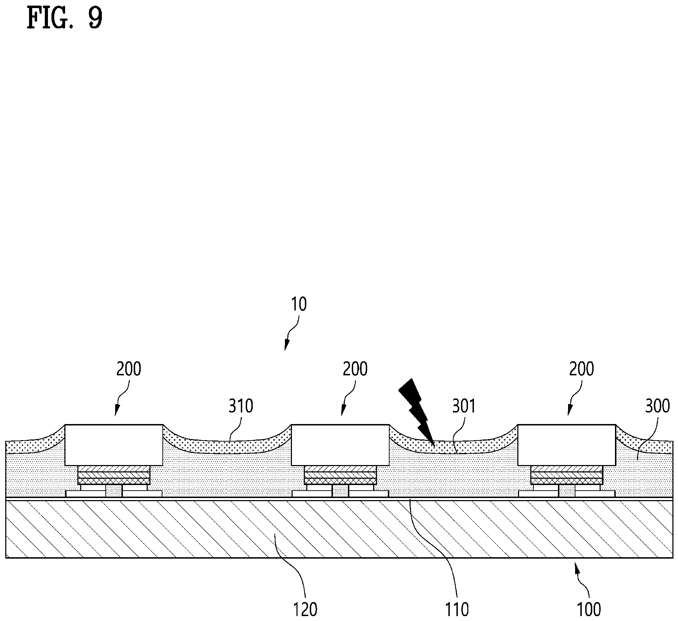

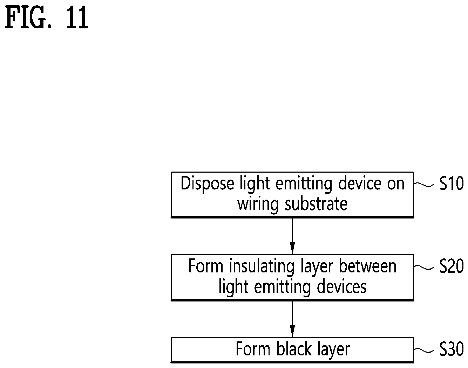

FIG. 9 is a schematic cross-sectional diagram illustrating a process of fabricating a display device using a light emitting device according to an embodiment of the present disclosure. FIG. 10 is a schematic diagram illustrating a partial region of FIG. 9. FIG. 11 is a flowchart illustrating a process of fabricating a display device using a light emitting device according to an embodiment of the present disclosure.

Referring to FIG. 9, a process of forming a black layer 310 is schematically illustrated.

Referring to FIG. 11 together, in a process for fabricating a display device using a light emitting device according to an embodiment of the present disclosure, first, a step S10 of disposing a plurality of light emitting devices 200 forming individual pixels on a wiring substrate 100 may be performed.

Thereafter, a step S20 of forming an insulating layer 300 including particles 303 dispersed in a transparent resin layer 302 between the light emitting devices 200 may be performed.

Next, a step S30 of forming a black layer 310 by applying heat to the insulating layer 300 may be performed.

FIG. 9 and FIG. 10 mainly illustrate the step S30 of forming the black layer 310 by applying heat to the insulating layer 300.

In an exemplary embodiment, the step of applying heat to the insulating layer 300, that is, the step S30 of forming the black layer 310 may be performed by laser irradiation. The black layer 310 may be formed by thermally decomposing the particles 303 included in the insulating layer 300 in a manner of applying heat to the insulating layer 300 by the laser irradiation. The resin (resin) may be carbonized by a pyrolysis process of the particles 303 or the transparent resin layer 302.

Such a carbonization phenomenon may be a phenomenon in which an organic material is pyrolyzed under appropriate conditions to generate non-crystalline carbon-black amorphous micropowder (soot).

That is, at least one of the transparent resin layer 302 and the particles 303 may be thermally decomposed by heat generated by irradiating a laser to the insulating layer 300, and in this process, non-crystalline carbon, for example, black amorphous micropowder may be generated.

As described above, the transparent resin layer 302 may be formed of a resin material. For example, the transparent resin layer 302 may include at least one of silicon, epoxy, and urethane. The material forming the transparent resin layer 302 may be changed in shape by laser light. That is, the resin material forming the transparent resin layer 302 may be carbonized by laser light to form the black layer 310.

The step S30 of forming the black layer 310 may be performed by irradiating laser light to all over the display 10. In this process, the laser light may react only to the insulating layer 300. That is, the light emitting device 200 may not react with the laser light. The laser light may penetrate the insulating layer 300 at a predetermined depth according to a set wavelength and power to apply heat thereto.

In the process of applying heat to the insulating layer 300, the light emitting devices 200 are disposed on the wiring substrate 100, and in a state in which the insulating layer 300 is formed between the light emitting devices 200, the laser light may be irradiated while moving along the entire wiring substrate 100. Alternatively, laser light may be irradiated while the wiring substrate 100 moves in a state in which the laser is fixed.

Referring to FIG. 10, a lens 350 that does not react to a laser irradiation may be disposed on the light emitting device 200.

Laser light may not react to the support layer 240 disposed on a top side of the light emitting device 200. The support layer 240 may be formed of a material such as sapphire, and the laser light may pass through the sapphire, but the power of the laser light may not damage the semiconductor structure 202.

However, the lens 350 may be positioned on the support layer 240 so that the laser light may not pass through the support layer 240 or the power for the laser light to pass through the support layer 240 may be adjusted to greatly decrease.

As described above, in FIG. 10, the laser light may form a reactive region R only on the insulating layer 300 and a non-reactive region N on the light emitting device 200.

Therefore, when the laser light passes from a left side to a right side in FIG. 10, the laser light may react to the insulating layer 300 only in the reaction region R located at the left and right sides of the light emitting device 200 to form the black layer 310.

Accordingly, the black layer 310 may include a material formed by transforming a material forming the insulating layer 300. In an exemplary embodiment, the black layer 310 may include a material formed by carbonizing particles included in the insulating layer 300.

In other words, the black layer 310 may include a material in which particles included in the insulating layer 300 are decomposed by heat. In this case, the material decomposed by the heat may include non-crystalline carbon or amorphous powder.

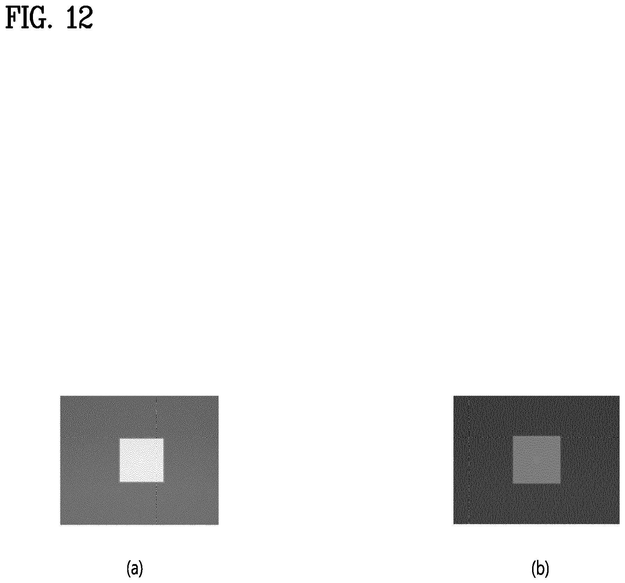

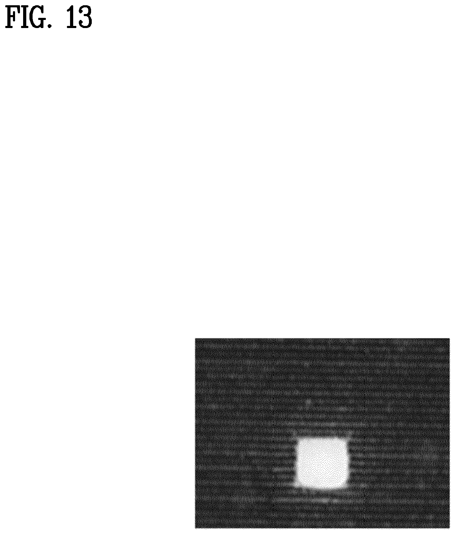

FIG. 12 illustrates an example of a grayscale representation in a state in which a black film is formed on a front surface of a display device as a comparative example, and FIG. 13 illustrates an example of a grayscale representation of a display device using a light emitting device according to an embodiment of the present disclosure.

Referring to FIG. 12, a black film is applied to a front surface including a top side of the light emitting device 200. FIG. 12 (a) shows a state before the black film is applied, and FIG. 12 (b) shows a state after the black film is applied.

Referring to FIG. 12 (a), it may be seen that a central white region is bright, but a periphery before application of the black film is not sufficiently dark. This may be a phenomenon in which a sapphire mainly used as the support layer 240 of the light emitting device 200 has a large reflectivity with respect to external incident light.

In addition, referring to FIG. 12 (b), it may be seen that a periphery is sufficiently dark but a central white region is darkened together by the application of the black film.

Therefore, according to the comparative example shown in FIG. 12, the contrast o of the display may be lowered, and it may be difficult to achieve sufficient grayscale representation.

Meanwhile, referring to FIG. 13 according to an embodiment of the present disclosure, since the black layer 310 is not positioned on the light emitting device 200, it may be seen that a central portion may be sufficiently bright, and a periphery may be sufficiently dark owing to an operation of the black layer 310.

That is, a light source (e.g., light emitting device 200) side may be represented to be sufficiently bright, and a periphery of the light source may be represented to be sufficiently dark. Accordingly, a grayscale representation by the light source may be widely implemented.

In addition, since the black layer 310 is not disposed on the light emitting device 200, the overall brightness of the display device may be improved.

In addition, light traveling to the side surface of the light emitting device 200 may proceed to a front surface, thereby increasing light efficiency.

In addition, viewing angles due to different light distribution characteristics among red, green, and blue may be uniformized.

The above description is merely illustrative of the technical idea of the present disclosure. Those of ordinary skill in the art to which the present disclosure pertains will be able to make various modifications and variations without departing from the essential characteristics of the present disclosure.

Therefore, embodiments disclosed in the present disclosure are not intended to limit the technical idea of the present disclosure, but to describe, and the scope of the technical idea of the present disclosure is not limited by such embodiments.

The scope of protection of the present disclosure should be interpreted by the claims below, and all technical ideas within the scope equivalent thereto should be construed as being included in the scope of the present disclosure.

### INDUSTRIAL APPLICABILITY

According to the present disclosure, a display device using a Light Emitting Diode (LED) may be provided.

## Claims

1. A display device, comprising:
a wiring substrate;
a light emitting device disposed as an individual pixel on the wiring substrate;
an insulating layer positioned on at least a side surface of the light emitting device; and
a black layer positioned on the insulating layer,
wherein the black layer includes a material formed by the transformation of a material constituting the insulating layer.

2. The display device of claim 1, wherein the black layer comprises a material formed by the carbonization of particles included in the insulating layer.

3. The display device of claim 1, wherein the black layer includes a material formed by the decomposition of particles included in the insulating layer due to heat.

4. The display device of claim 3, wherein the material formed by the decomposition of particles due to the heat comprises non-crystalline carbon and amorphous powder.

5. The display device of claim 1, wherein the black layer has a predetermined thickness on the insulating layer.

6. The display device of claim 1, wherein the insulating layer acts as a reflective layer.

7. The display device of claim 1, the insulating layer comprising:
a transparent resin layer; and
particles dispersed within the transparent resin layer.

8. The display device of claim 7, wherein the transparent resin layer comprises at least one of silicon, epoxy, or urethane.

9. The display device of claim 7, wherein the particle comprises at least one of silicon oxide, titanium oxide, or zirconium oxide.

10. The display device of claim 7, wherein a refractive index of the particle is different from that of the transparent resin layer.

11. The display device of claim 1, wherein the light emitting device comprises a semiconductor structure having a plurality of semiconductor layers stacked to emit light of a first color, a second color, and a third color.

12. The display device of claim 11, wherein the light emitting device comprises a support layer on the semiconductor structure.

13. The display device of claim 12, wherein the insulating layer is positioned to further surround a side surface of the support layer.

14. The display device of claim 12, wherein the black layer is positioned to surround at least a portion of a side surface of the support layer.

15. A method of fabricating a display device using a light emitting device, the method comprising:
disposing a plurality of light emitting devices forming individual pixels on a wiring substrate;
forming an insulating layer including particles dispersed within a transparent resin layer between the light emitting devices; and
forming a black layer by applying heat to the insulating layer.

16. The method of claim 15, wherein the forming the black layer is performed by laser irradiation.

17. The method of claim 16, wherein the forming the black layer comprises thermally decomposing particles included in the insulating layer by applying the heat.

18. The method of claim 17, wherein the terminally decomposed particles comprise non-crystalline carbon and amorphous powder.

19. The method of claim 15, wherein a lens is positioned on the light emitting device so as not to react to the laser irradiation.

20. The method of claim 15, the insulating layer comprising:
a transparent resin layer; and
particles dispersed within the transparent resin layer.
